# EUROPEAN PATENT SPECIFICATION

(11) **EP 0 713 290 B1**
(45) Date of publication and mention of the grant of the patent: **29.08.2001**
(21) Application number: 95118072.8
(22) Date of filing: 16.11.1995
(51) Int. Cl.: H03H 2/00

(54) **Magnetostatic wave device having disk shape**
Scheibenförmige magnetostatische Wellenanordnung
Dispositif à ondes magnétostatiques en forme de disque

(30) Priority: 17.11.1994 JP 30999594
(43) Date of publication of application: 22.05.1996
(73) Proprietor: MURATA MANUFACTURING CO., LTD., Nagaokakyo-shi Kyoto-fu 226 (JP)
(72) Inventor: Okada, Takekazu, Nagaokakyo-shi, Kyoto-fu (JP); Shinmura, Satoru, Nagaokakyo-shi, Kyoto-fu (JP); Kanaya, Fumio, Nagaokakyo-shi, Kyoto-fu (JP)
(74) Representative: Schoppe, Fritz, Dipl.-Ing.

(56) References cited:
- US-A- 4 555 683
- US-A- 4 595 889
- PROCEEDINGS OF THE IEEE, vol. 76, no. 2, February 1988 NEW YORK US, pages 159-170, XP 000002739 J.D. ADAM 'Analog signal processing with microwave magnetics'

## Description

### BACKGROUND OF THE INVENTION

### Field of the invention

The present invention generally relates to a magnetostatic wave device. More specifically, the present invention relates to a magnetostatic wave device using a ferrimagnetic base, which is utilized as an S/N enhancer and a filter.

### Description of the Related Art

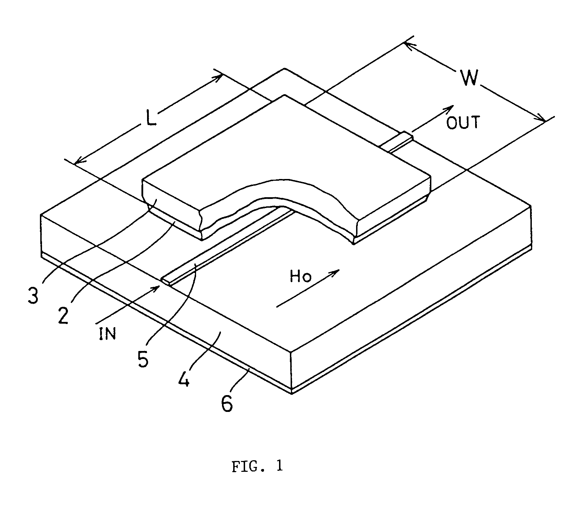

One typical S/N enhancer which may constitute the background art of the present invention is disclosed in, for instance, 1980 IEEE TRANSACTIONS ON MAGNETICS, Vol. MAG-16, pages 1168 to 1170, entitled "A BROADBAND MICROWAVE SIGNAL TO NOISE ENHANCER", and U.S. Patent No. 4,283,692. Fig 1 is a perspective view for representing such a typical S/N enhancer. The S/N enhancer 1 indicated in Fig. 1 includes a rectangular- plate-shaped YIG thin film 2 functioning as a ferrimagnetic base. This YIG thin film 2 is fabricated on one major surface of a rectangular-plate-shaped GGG substrate 3. A surface of the YIG thin film 2 is caused to adhere to a center portion of one major surface of a rectangular-plate-shaped dielectric substrate 4. A straight-shaped microstrip line 5 is formed as a transducer on a center portion of one major surface of this dielectric substrate 4 along a width direction thereof in such a manner that this microstrip line 5 intersects the YIG thin film 2. One end of an input terminal (not shown) is connected to one end of the microstrip line 5, whereas one end of an output terminal (not shown either) is connected to the other end of this microstrip line 5. A ground electrode 6 is formed on the other major surface of the dielectric substrate 2. It should be noted that the other end of the input terminal and the other end of the output terminal are grounded, respectively.

The document US-A-4,595,889 also discloses a magnetostatic wave device where a microstrip line is placed on a single side of a substrate base.

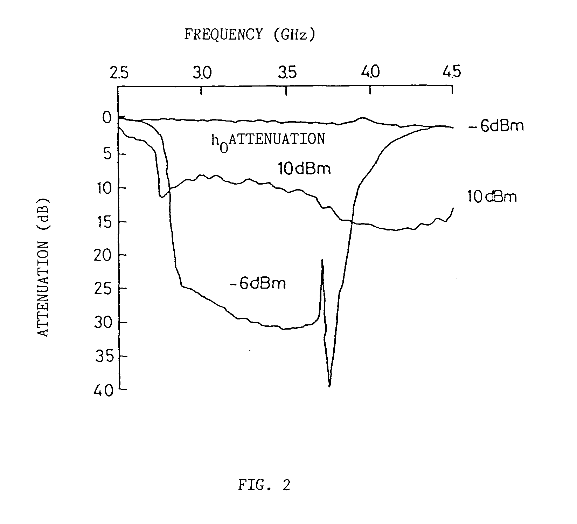

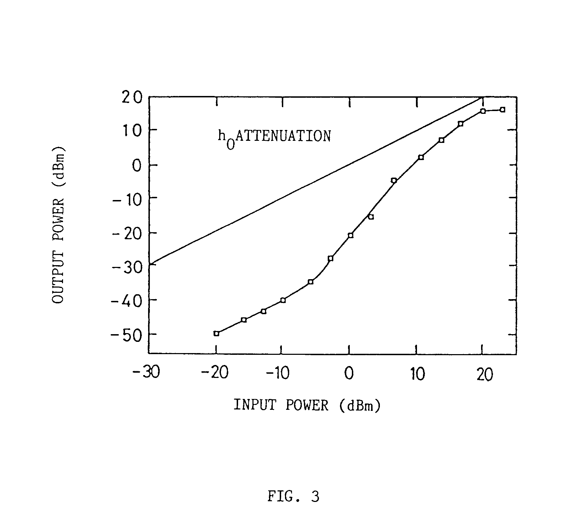

In the S/N enhancer 1 shown in Fig. 1, the DC magnetic field Ho is applied to the YIG thin film 2 functioning as the ferrimagnetic base along the longitudinal direction of the microstrip line 5. Then, in this S/N enhancer 1, when RF (high frequency) power is supplied to the input terminal thereof, the RF magnetic field is produced around the microstrip line 5, so that the magnetostatic surface wave (MSSW), which is one of three modes of magnetostatic waves, is excited within the YIG thin film 2. When the RF power supplied to the input terminal is low, since the substantial portion of this RF power is converted into the magnetostatic wave, the output power derived from the output terminal becomes very low. On the other hand, when the RF power supplied to the input terminal is high, since the conversion from the RF power into the magnetostatic wave is saturated, the substantial portion of the RF power is obtained via the microstrip line 5 from the output terminal. As a consequence, substantially no noise component whose input power is low is outputted, but the substantial portion of the signal component whose input power is high may be outputted from this S/N enhancer 1. Therefore, the signal-to-noise ratio can be increased in this S/N enhancer 1. The frequency characteristics at -6 dBm and 10 dBm in this S/N enhancer 1 are indicated in Fig. 2, and the input/output characteristic at 3.3 GHz thereof is represented in Fig. 3

In the S/N enhancer 1 shown in Fig. 1, the noise attenuation amount is determined based upon the length "L" of the portion of the YIG thin film 2 functioning as the ferrimagnetic base, which is located opposite to the portion of the microstrip line 5 functioning as the transducer. It should be noted that this length "L" is selected to be 2.1 cm in this S/N enhancer 1. Then, when the noise attenuation amount is increased in the S/N enhancer 1, it is an effective measure to increase this length "L". However, this measure may cause such a problem that the dimension of such a high-cost ferrimagnetic base, e.g., the YIG thin film becomes large. In other words, when the YIG thin film 2 is made small so as to achieve such a compact and low-cost S/N enhancer 1, the length "L" of the portion of the YIG thin film 2, which is located opposite to that of the microstrip line 5 would become short, and thus the noise attenuation amount would be lowered.

Also, in the S/N enhancer 1 of Fig. 1, the converted magnetostatic wave is reflected on the microstrip line 5 from the edge portion of the YIG thin film, and then this reflected magnetostatic wave may be transformed into RF power by parts of the S/N enhancer 1 such as the microstrip line 5. When there is such a reflected magnetostatic wave, this magnetostatic wave may appear as ripple components of the amplitude and the phase within the transmission band of the S/N enhancer 1. As a consequence, such various demands are required so as to reduce reflections of the magnetostatic wave in this S/N enhancer 1. That is, the length of the magnetostatic wave along the propagating direction, namely the width "W" of the YIG thin film 2 is increased, and further the magnetostatic wave absorbing member is provided at the edge portion of the YIG thin film 2.

### SUMMARY OF THE INVENTION

The present invention has been made in attempt to solve the above-described problems, and therefore, has an object to provide a compact magnetostatic wave device manufactured at low cost.

To achieve this object, a magnetostatic wave device, according to one aspect of the present invention, is characterized by comprising:
a ferrimagnetic base;
a transducer having a portion arranged on one surface side of said ferrimagnetic base and another portion arranged on the other surface side of said ferrimagnetic base;
an input terminal whose one end is connected to one end of said transducer and whose the other end is grounded; and
an output terminal whose one end is connected to the other end of said transducer and whose the other end is grounded.

In the magnetostatic wave device according to the present invention, it is preferable to manufacture the ferrimagnetic base in a disk shape due to the below-mentioned reason.

Also, the magnetostatic wave device, according to the present invention, preferably further includes another transducer having a portion arranged on one major surface of said ferrimagnetic base and another portion arranged on the other major surface of said ferrimagnetic base, and connected in parallel to said transducer, due to the below-mentioned reason.

Another magnetostatic wave device, according to another aspect of the present invention, is comprised of:
a ferrimagnetic base;
one transducer having a portion arranged on one surface side of said ferrimagnetic base and another portion arranged on the other surface side of said ferrimagnetic base;
another transducer having a portion arranged on the other major surface side of said ferrimagnetic base and another portion arranged on one major surface side of said ferrimagnetic base;
an input terminal whose one end is connected to one end of said one transducer and whose the other end is connected to one end of said another transducer; and
an output terminal whose one end is connected to the other end of said one transducer and whose the other end is connected to the other end of said another transducer.

In the magnetostatic wave device according to the present invention, it is preferable to manufacture the ferrimagnetic base in a disk shape due to the below-mentioned reason.

In the magnetostatic wave device according to the present invention, when the DC magnetic field is applied to the ferrimagnetic base and also the RF power is applied to the input terminal, the RF (high frequency) magnetic field is produced around the transducer, so that the magnetostatic wave is excited within the ferrimagnetic base. When the RF power inputted to the input terminal is low, this RF power is converted or transformed into the magnetostatic wave. Since the transducer owns a portion arranged at one major surface of the ferrimagnetic base and another portion arranged at the other major surface of the ferrimagnetic base, the conversion efficiency from the RF power into the magnetostatic wave is increased. Therefore, even when the dimension of the ferrimagnetic base is made small, a similar noise attenuation amount to the conventional noise attenuation amount can be obtained. On the other hand, when the RF power inputted to the input terminal is high, since the converting operation from the RF power into the magnetostatic wave is saturated, a major portion of this RF power may be derived from the output terminal through the transducer. As a consequence, in this magnetostatic wave apparatus, the substantially no noise component having the low input power is outputted, whereas the substantial amount of the signal component having the high input power is outputted. In other words, the signal-to-noise (S/N) ratio of this magnetostatic wave apparatus can be increased.

In another magnetostatic wave device according to the present invention, when the DC magnetic field is applied to the ferrimagnetic base and also the RF (or high frequency) power is inputted to the input terminal, the RF (or high frequency) magnetic field is produced around one and another transducers, so that the magnetostatic wave is excited within the ferrimagnetic base. When the RF power inputted to the input terminal is low, this RF power is converted or transformed into the magnetostatic wave. Since one transducer owns a portion arranged at one major surface of the ferrimagnetic base and another portion arranged at the other major surface of the ferrimagnetic base, and also another transducer has a portion arranged at the other major surface of the ferrimagnetic base and another portion at one major surface of the ferrimagnetic base, the conversion efficiency from the RF power into the magnetostatic wave is increased. Therefore, even when the dimension of the ferrimagnetic base is made small, a similar noise attenuation amount to the conventional noise attenuation amount can be obtained. On the other hand, when the RF power inputted to the input terminal is high, since the converting operation from the RF power into the magnetostatic wave is saturated, a major portion of this RF power may be derived from the output terminal through one and another transducers. As a consequence, in this magnetostatic wave device, the substantially no noise component having the low input power is outputted, whereas the substantial amount of the signal component having the high input power is outputted. In other words, the signal-to-noise (S/N) ratio of this magnetostatic wave device according to the invention can be increased.

In accordance with the present invention, since the conversion efficiency from the RF power into the magnetostatic wave is improved, the compact magnetostatic wave apparatus can be made at low cost.

Also, in the magnetostatic wave device of the present invention, when the ferrimagnetic base is made in a disk shape, the converted magnetostatic wave can be hardly reflected on the transducer from the edge portion of the ferrimagnetic base. As a consequence, the magnetostatic wave reflected from the edge portion of the ferrimagnetic base can be hardly converted into the RF power by parts of the magnetostatic wave device such as the transducer. Thus, the amplitude/phase ripple components are lowered within the transmission band of the magnetostatic wave device, and the resultant characteristic thereof can be improved. Even when the ferrimagnetic base is made in a disk shape in another magnetostatic wave device according to the present invention, a similar advantage may be achieved.

Furthermore, in the magnetostatic wave device according to the present invention, when it includes another transducer having a portion arranged on one major surface of the ferrimagnetic base and another portion arranged on the other major surface of the ferrimagnetic base, and connected in parallel to the transducer, one transducer and another transducer are parallel-connected between the input terminal and the output terminal. As a result, the impedance between the input terminal and the output terminal may be lowered and the insertion loss may be reduced.

Also, in another magnetostatic wave device according to the present invention, one transducer owns the portion arranged on one major surface side of the ferrimagnetic base and the portion arranged on the other major surface side of the ferrimagnetic base, and also another transducer has the portion arranged on the other major surface side of the ferrimagnetic base and the portion arranged on one major surface portion of this ferrimagnetic base. Further, both one end and the other end of the input terminal are connected to one end of one transducer and one end of another transducer, respectively. Both one end and the other end of the output terminal are connected to the other end of the transducer and the other end of another transducer, respectively. In other words, since such a condition is established that the input terminal and the output terminal are connected to each other by the two transducers, as in the case of connecting to each other by a feeder, even when the lengths of one transducer and the other transducer are made long in order to increase the noise attenuation amount, there is substantially no change in the impedance between the input terminal and the output terminal, and thus the insertion loss does not become large.

### BRIEF DESCRIPTION OF THE DRAWINGS

The above-described object and other objects of the present invention, features and also advantages will become more apparent from the following detailed descriptions in conjunction with the accompanying drawings, in which:
Fig. 1 is a perspective view for indicating one typical example of the conventional S/N enhancer;
Fig. 2 is a graphic representation of the frequency characteristic of the conventional S/N enhancer shown in Fig. 1;
Fig. 3 is a graphic representation of the input/output characteristic of the conventional S/N enhancer shown in Fig. 1;
Fig. 4 is a perspective view for representing an S/N enhancer according to an embodiment of the present invention;
Fig. 5 is a perspective view for indicating an S/N enhancer according to a modification of the present invention;
Fig. 6 is a perspective view for showing an S/N enhancer according to another modification of the present invention;
Fig. 7 is a perspective view for showing an S/N enhancer according to a further modification of the present invention;
Fig. 8 is a perspective view for indicating an S/N enhancer according to a still further modification of the present invention;
Fig. 9 is a perspective view for representing a comparison example;
Fig. 10 is a graphic representation for showing frequency characteristics about the respective embodiments shown in Fig. 5 to Fig. 8 and the comparison example shown in Fig. 9;
Fig. 11 is a graphic representation for showing input/output characteristics about the respective embodiments shown in Fig. 5 to Fig. 8 and the comparison example shown in Fig. 9;
Fig. 12 is a fragmentary perspective view for indicating an S/N enhancer according to another embodiment of the present invention;
Fig. 13 is a perspective view for showing an S/N enhancer according to a further embodiment of the present invention;
Fig. 14 is a plan view for denoting the S/N enhancer of Fig. 13;
Fig. 15 is a fragmentary perspective view for representing a major portion of the S/N enhancer shown in Fig. 13;
Fig. 16 is a perspective view for showing an S/N enhancer according to another embodiment of the present invention;
Fig. 17 is a perspective view for representing an S/N enhancer according to a still further embodiment of the present invention; and
Fig. 18 is a schematic block diagram for showing an application example of the S/N enhancer indicated in Fig. 17.
Fig 19(A) and 19(B) are side views showing YIG films 12 and the GGG substrate 14 according to modifications of the embodiment shown in Fig. 4, Fig. 12 to 17 and Fig. 5 to 8 respectively.

### DETAILED DESCRIPTION OF THE PREFERRED EMBODIMENTS

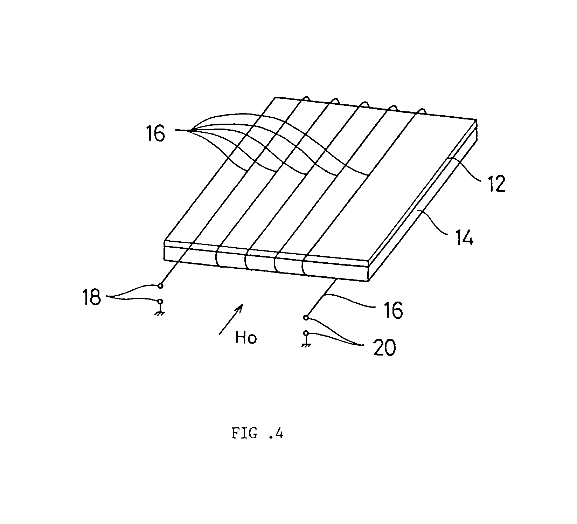

Fig. 4 is a perspective view for indicating an S/N enhancer 10 functioning as a magnetostatic wave device according to an embodiment of the present invention. The S/N enhancer 10 includes a YIG thin film 12 having, for example, a rectangular plate shape, which functions as a ferrimagnetic base. This YIG thin film 12 is formed on, for example, one major surface of a rectangular-plate-shaped GGG substrate 14. A transducer 16 made of, e.g., a conductive wire is wound around the YIG thin film 12 and the GGG substrate 14 by 5 turns. As a result, this transducer 16 owns 5 portions arranged substantially parallel to one major surface of the YIG thin film 12, and also 5 portions arranged substantially parallel to the other major surface of the YIG thin film 12. One end of an input terminal 18 is connected to one end of the transducer 16, and one end of an output terminal 20 is connected to the other end of this transducer 16. Furthermore, both of the other end of this input terminal 18 and the other end of this output terminal 20 are grounded.

In the S/N enhancer 10 shown in Fig. 4, the DC magnetic field "Ho" is applied to the YIG thin film 12 functioning as the ferrimagnetic base along a direction parallel to the major surface of the YIG thin film 12 as well as parallel to the transducer 16. Then, when the RF (or high frequency) power is inputted to the input terminal 18, the RF (or high frequency) magnetic field is produced around the transducer 16, so that the magnetostatic surface wave is excited within the YIG thin film 12. When the RF power inputted to the input terminal 18 is low, this RF power is converted or transformed into the magnetostatic wave. Since the transducer 16 owns a portion arranged at one major surface of the YIG thin film 12 and another portion arranged at the other major surface of the YIG thin film 12, the conversion efficiency from the RF power into the magnetostatic wave is increased. Therefore, even when the dimension of the YIG thin film 12 is made small, a similar noise attenuation amount to the conventional noise attenuation amount can be obtained. On the other hand, when the RF power inputted to the input terminal 18 is high, since the converting operation from the RF power into the magnetostatic wave is saturated, a major portion of this RF power may be derived from the output terminal 20 through the transducer 16. As a consequence, in this S/N enhancer 10, the substantially no noise component having the low input power is outputted, whereas the substantial amount of the signal component having the high input power is outputted. In other words, the signal-to-noise (S/N) ratio of this S/N enhancer 10 can be increased. Furthermore, since the conversion efficiency from the RF power into the magnetostatic wave is improved in this S/N enhancer 10, the resultant S/N enhancer 10 can be made compact in low cost.

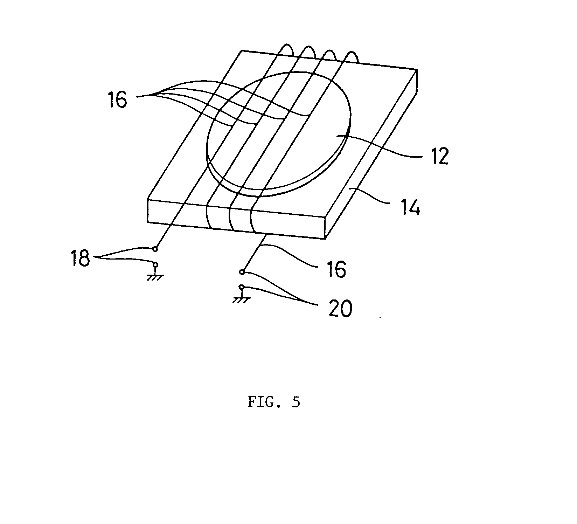

Fig. 5 is a perspective view for showing an S/N enhancer according to one modification about the S/N enhancer of Fig. 4. In the S/N enhancer of this modification, the YIG thin film 12 is fabricated in a disk shape on a center portion of one major surface of the GGG substrate 14, and furthermore, the transducer 16 is wound around the YIG thin film 12 and the GGG substrate 14 by 4 turns, as compared with the above-described embodiment indicated in Fig. 4.

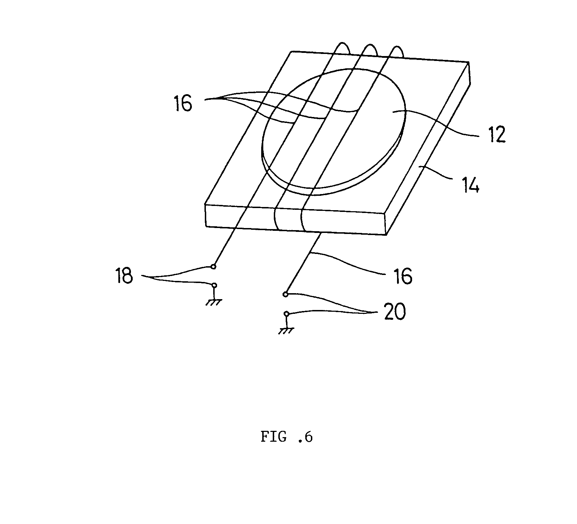

Fig. 6 is a perspective view for representing an S/N enhancer according to one modification about the S/N enhancer of Fig. 5. In the S/N enhancer of this modification of Fig. 6, the transducer 16 is wound around the YIG thin film 12 and the GGG substrate 14 by 3 turns, as compared with the above-described embodiment shown in Fig. 5.

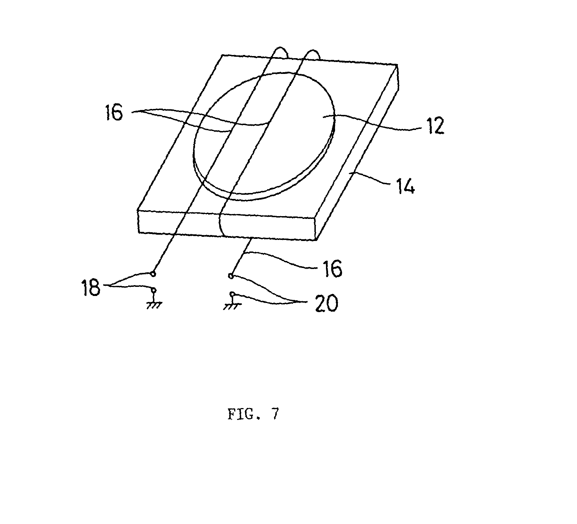

Fig. 7 is a perspective view for showing an S/N enhancer according to another modification about the S/N enhancer of Fig. 5. In the S/N enhancer of this modification of Fig. 7, the transducer 16 is wound around the YIG thin film 12 and the GGG substrate 14 by 2 turns, as compared with the above-described embodiment shown in Fig. 5.

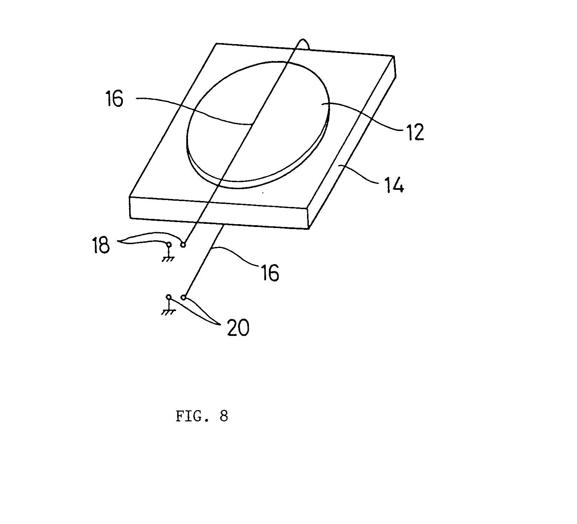

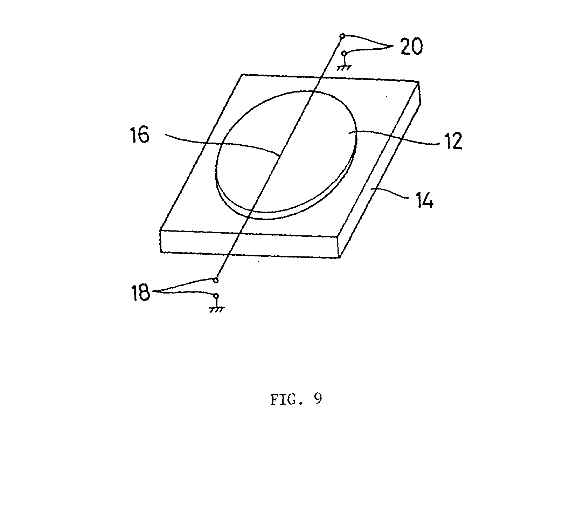

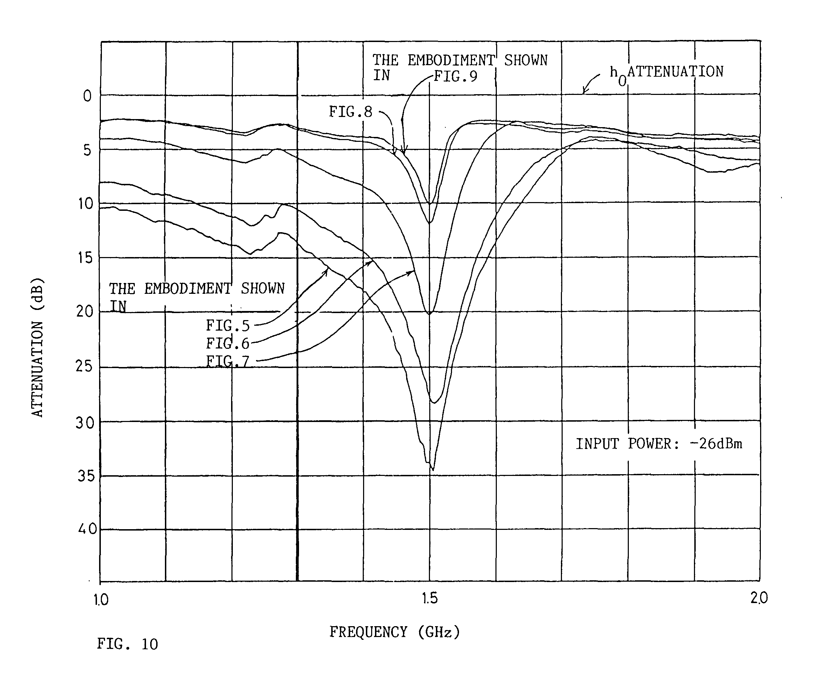

Fig. 8 is a perspective view for representing an S/N enhancer according to a fourth modification about the S/N enhancer of Fig. 5. In the S/N enhancer of this modification of Fig. 8, the transducer 16 is wound around the YIG thin film 12 and the GGG substrate 14 by 1 turn, as compared with the above-described embodiment shown in Fig. 5.

Similar to the embodiment of Fig. 4, also in the respective modifications of Fig. 5 to Fig. 8, the transducer 16 owns such a portion arranged on one major surface of the YIG thin film 12 and also such a portion arranged on the other major surface of the YIG thin film 12. As a consequence, the conversion (transform) efficiency from the input RF power into the magnetostatic wave can be increased, and the S/N enhancers can be made compact, at low cost.

Moreover, in the respective modified S/N enhancers shown in Fig. 5 to Fig. 8, since the YIG thin film 12 is manufactured in a disk shape, the converted magnetostatic wave can be hardly reflected on the transducer 16 from the edge portion of the YIG thin film 12. Therefore, the magnetostatic wave reflected from the edge portion of the YIG thin film 12 can be hardly transformed into the RF power by parts of the magnetostatic wave device such as the transducer 16. As a consequence, the amplitude/phase ripple components are lowered within the transmission bands of the S/N enhancers, so that the characteristics thereof can be improved.

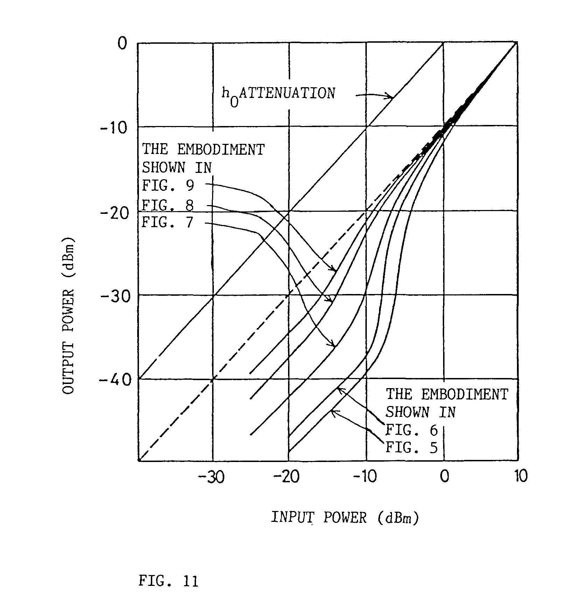

Fig. 9 is a perspective view for representing a comparison example. In the S/N enhancer according to this comparison example of Fig. 9, a straight line shaped transducer 16 is arranged only on one major surface of the YIG thin film 12, as compared with the embodiment of Fig. 5.

In Fig. 10, there are graphically represented frequency characteristics of the respective embodiments shown in Fig. 5 to Fig. 8, and of the comparison example indicated in Fig. 9. In Fig. 11, there are indicated input/output characteristics of the respective embodiments shown in Fig. 5 to Fig. 8, and of the comparison example denoted in Fig. 9. It should be noted that a thickness of the YIG thin film 12 is 95 *µ*m, a diameter of this YIG thin film 12 is 2.2 mm, and saturation magnetization 4πMs of this YIG thin film 12 is 1,780 Gauss.

As apparent from the frequency characteristics shown in Fig. 10 and also the input/output characteristics indicated in Fig. 11, when the turning member of the transducer 16 is increased, the noise attenuation amount would be increased. As a result, both of the frequency characteristics and the input/output characteristics could be improved. It should be understood that when the turning member of the transducer 16 is increased, the impedance is increased. Accordingly, the final turning member of the transducer 16 may be properly selected, taking account of the noise attenuation amount and the impedance value.

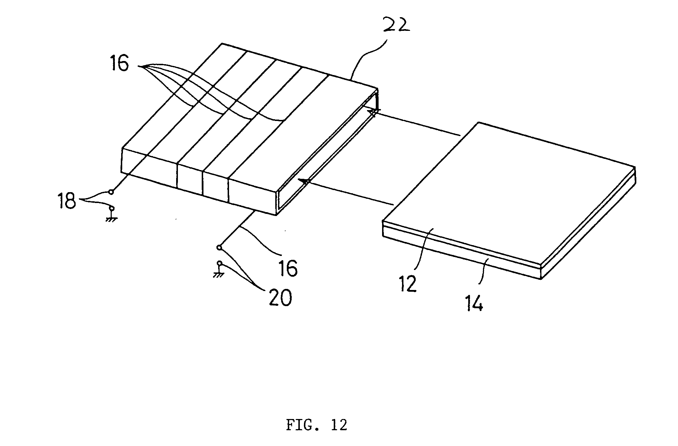

Fig. 12 is a perspective view for indicating an S/N enhancer according to another embodiment of the present invention. In this S/N enhancer shown in Fig. 12, both of the YIG thin film 12 and the GGG substrate 14 are especially stored within a prism-shaped case 22 made of a non-magnetic material and having an insulating characteristic, and the transducer 16 made of the conductive wire is wound around the case 22 by 4 turns.

Also in the embodiment shown in Fig. 12, the transducer 16 owns such a portion arranged on one major surface of the YIG thin film 12 and also such a portion arranged on the other major surface of the YIG thin film 12. As a consequence, the conversion (transform) efficiency from the input RF power into the magnetostatic wave can be increased, and the S/N enhancers can be made compact, at low cost.

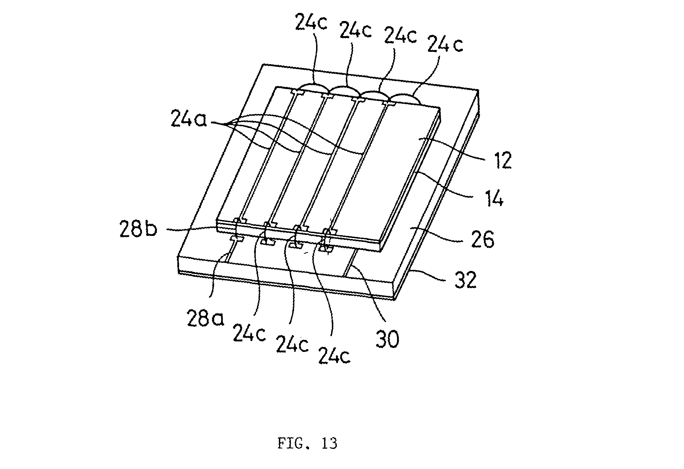

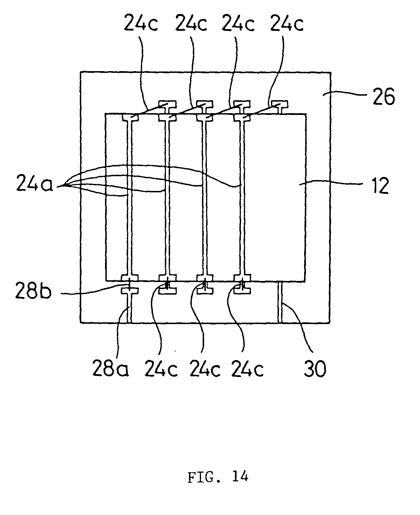

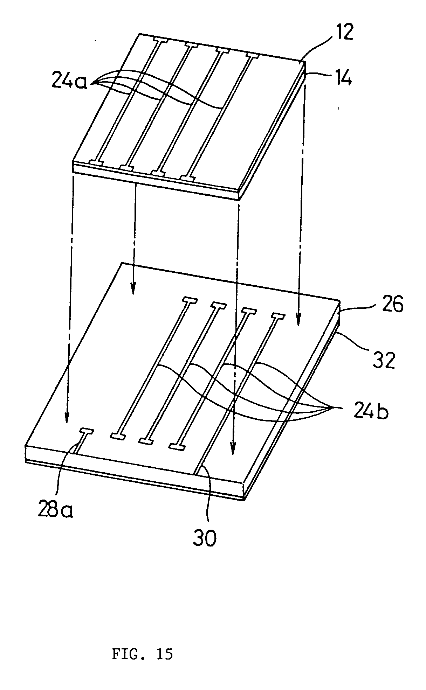

Fig. 13 is a perspective view for representing an S/N enhancer according to a further embodiment of the present invention. Fig. 14 is a plan view for indicating this S/N enhancer of Fig. 13, and Fig. 15 is a fragmentary perspective view for representing a major portion of this S/N enhancer. In the embodiment shown in Fig. 13 to Fig. 15, in particular, 4 sets of straight line electrodes 24a are formed on the surface of the YIG thin film 12 in parallel to each other in a preselected interval. The surface of the GGG substrate 14 is caused to adhere to a center portion of one major surface of a dielectric substrate 26. Also, 4 sets of straight line electrodes 24b are fabricated at the center portion of one major surface of this dielectric substrate 26 in parallel to each other in a preselected interval, then, predetermined edge portions of these line electrodes 24a and 24b are connected to each other by a conductive wire 24c, so that such a coil-shaped transducer is constituted which is wound around the YIG thin film 12 and the GGG substrate 14 by 4 turns. One end of the transducer, namely one end portion of one line electrode 24a is connected to a terminal electrode 28a formed on one major surface of the dielectric substrate 26 by using a conductive wire 28b. This terminal electrode 28a is employed as one end of an input terminal. The other end of this transducer, namely the other end portion 30 of one line electrode 24b is fabricated in such a manner that the other end portion 30 is elongated to the edge portion of the dielectric substrate 26. This other end portion 30 is employed as one end of an output terminal. Furthermore, an earth electrode 32 is formed on the other major surface of the dielectric substrate 26. This earth electrode 32 is utilized as the other end of the input terminal and the other end of the output terminal.

Also, in the respective embodiments of Fig. 13 to Fig. 15, the transducer owns such a portion arranged on one major surface of the YIG thin film 12 and also such a portion arranged on the other major surface of the YIG thin film 12. As a consequence, the conversion (transform) efficiency from the input RF power into the magnetostatic wave can be increased, and the S/N enhancers can be made compact, at low cost.

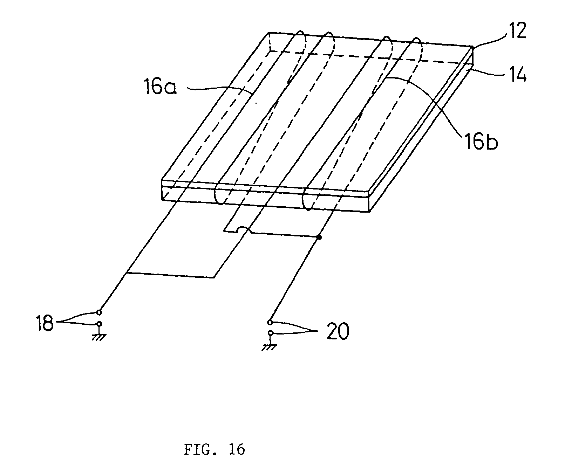

Fig. 16 is a perspective view for indicating an S/N enhancer according to another embodiment of the present invention. In this embodiment of Fig. 16, a transducer 16a made of a conductive wire is wound around a half portion of the YIG thin film 12 and the GGG substrate 14, respectively by 2 turns. Similarly, another transducer 16b made of a conductive wire is wound around the remaining half portion of the respective YIG thin film 12 and GGG substrate 14. Then, one end of one transducer 16a and one end of another transducer 16b are connected to one end of the input terminal 18. Both of the other end of one transducer 16a and the other end of the other transducer 16b are connected to one end of the output terminal 20. The other ends of these input terminal 18/output terminal 20 are grounded, respectively.

Also, in this embodiment shown in Fig. 16, one transducer 16a and another transducer 16b each has a portion arranged on one major surface of the YIG thin film 12 and also such a portion arranged on the other major surface of the YIG thin film 12. As a consequence, the conversion (transform) efficiency from the input RF power into the magnetostatic wave can be increased, and the S/N enhancers can be made compact, at low cost.

Further, in the S/N enhancer of Fig. 16, since one transducer 16a and another transducer 16b are parallel-connected between the input terminal 18 and the output terminal 20, the impedance between the input terminal 18 and the output terminal 20 is reduced and thus the insertion loss is lowered.

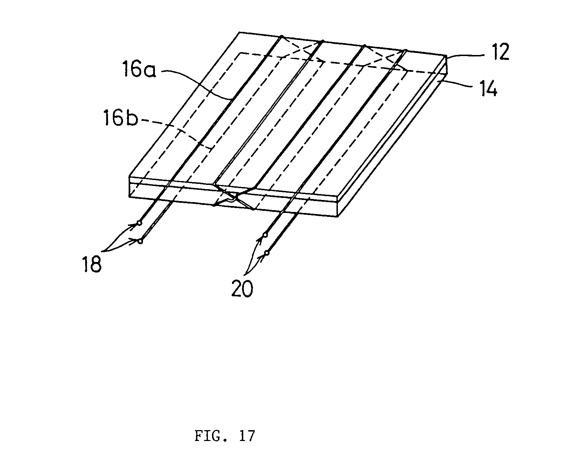

Fig. 17 is a perspective view for indicating an S/N enhancer according to a further embodiment of the present invention. In this embodiment of Fig. 17, a transducer 16a made of a conductive wire is wound around the YIG thin film 12 and the GGG substrate 14 by 2 turns. Moreover, another transducer 16b made of a conductive wire is wound around the YIG thin film 12 and the GGG substrate 14 by 2 turns in such a manner that this transducer 16b is located opposite to the first-mentioned transducer 16a by sandwiching the YIG thin film 12 and the GGG substrate 14.

Then, one end of one transducer 16a and one end of another transducer 16b are connected to one end of the input terminal 18 and the other end of the input terminal 18, respectively. Both of the other end of one transducer 16a and the other end of the other transducer 16b are connected to one end of the output terminal 20 and the other end of the output terminal 20, respectively.

In the S/N enhancer 10 shown in Fig. 17, the DC magnetic field "Ho" is applied to the YIG thin film 12 functioning as the ferrimagnetic base along a direction parallel to the major surface of the YIG thin film 12 as well as parallel to the transducers 16a and 16b. Then, when the RF (or high frequency) power is inputted to the input terminal 18, the RF (or high frequency) magnetic field is produced around the transducers 16a and 16b, so that the magnetostatic surface wave is excited within the YIG thin film 12. When the RF power inputted to the input terminal 18 is low, this RF power is converted or transformed into the magnetostatic wave. Since one transducer 16a owns a portion arranged at one major surface of the YIG thin film 12 and another portion arranged at the other major surface of the YIG thin film 12, and also another transducer 16b has a portion arranged at the other major surface of the YIG thin film and another portion arranged at one major surface of the YIG thin film 12, the conversion efficiency from the RF power into the magnetostatic wave is increased. Therefore, even when the dimension of the YIG thin film 12 is made small, a similar noise attenuation amount to the conventional noise attenuation amount can be obtained. On the other hand, when the RF power inputted to the input terminal 18 is high, since the converting operation from the RF power into the magnetostatic wave is saturated, a major portion of this RF power may be derived from the output terminal 20 through one transducer 16a and another transducer 16b. As a consequence, in this S/N enhancer 10 of Fig. 17, the substantially no noise component having the low input power is outputted, whereas the substantial amount of the signal component having the high input power is outputted. In other words, the signal-to-noise (S/N) ratio of this S/N enhancer 10 can also be increased. Furthermore, since the conversion efficiency from the RF power into the magnetostatic wave is improved in this S/N enhancer 10, the resultant S/N enhancer 10 can be made compact, at low cost.

Additionally, in the S/N enhancer 10 shown in Fig. 17, one transducer 16a owns the portion arranged on one major surface side of the YIG thin film 12 and the portion arranged on the other major surface side of the YIG thin film 12, and also another transducer 16b has the portion arranged on the other major surface side of the YIG thin film 12 and the portion arranged on one major surface portion of this YIG thin film 12. Further, both one end and the other end of the input terminal 18 are connected to one end of one transducer 16a and one end of another transducer 16b, respectively. Both one end and the other end of the output terminal 20 are connected to the other end of the transducer 16a and the other end of another transducer 16b, respectively. In other words, since such a condition is established that the input terminal 18 and the output terminal 20 are connected to each other by two transducers 16a and 16b, as in the case of connecting to each other by a feeder, even when the lengths of one transducer 16a and the other transducer 16b are made long in order to increase the noise attenuation amount, there is substantially no change in the impedance between the input terminal 18 and the output terminal 20, and thus the insertion loss does not become large.

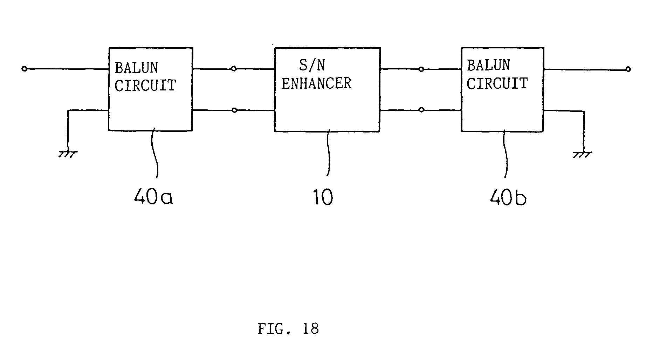

It should be noted that an impedance matching circuit may be employed at a prestage of the input side, and a poststage of the output side in each of the above-explained embodiments. In the S/N enhancer 10 shown in Fig. 17, the signal-to-noise ratio in the balanced transmission line can be improved. When a balun (balanced converter) circuit 40a is provided at a prestage of the input side and another balun circuit 40b is employed at a poststage of the output side in the enhancer 10 of Fig. 17 as illustrated in Fig. 18, the signal-to-noise ratio in the unbalanced transmission line may be improved. Conversely, the signal-to-noise ratio of the unbalanced transmission line can be improved in any embodiments other than the embodiment shown in Fig. 17. If the balun circuits 40a and 40b are provided at the prestage of the input side and the poststage of the output side in such a manner that an input and output of the balun circuits 40a and 40b are respectively connected in reverse order with respect to how they are connected in the embodiment shown in Fig. 17, then the signal-to-noise ratio in the balanced transmission line may be improved.

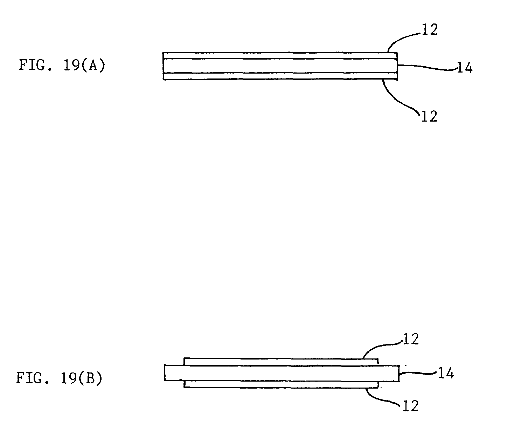

Although the YIG thin film 12 is formed on one major surface of the GGG substrate 14 in the respective embodiments of Fig. 4 to 8 and Fig. 12 to 17, two YIG films 12 may also be formed on the two major surfaces of the GGG substrate 14 as shown in Fig. 19(A) and 19(B)

Applying two YIG thin films 12 to these embodiments will achieve advantages similar to those of the embodiments in Fig. 4 to 8 and Fig. 12 to 17.

Although the YIG thin films are made in the disk shape in the respective embodiments shown in Fig. 5 to Fig. 8, other YIG thin films functioning as the ferrimagnetic base may be made in a disk shape in other embodiments. Also in this case, these embodiments may achieve a similar effect to that of the embodiments indicated in Fig. 5 to Fig. 8.

In the embodiment of Fig. 12, the transducer is formed around the case for surrounding the YIG thin film. Alternatively, the transducers may be fabricated around the cases for surrounding the YIG thin film functioning as the ferrimagnetic base in other embodiments.

Moreover, a portion of the transducer in the embodiments of Fig. 13 to Fig. 15 is formed by the electrode. Also in other embodiments, at least a portion of each of one transducer and another transducer may be formed by the electrode.

The two transducers are connected between the input terminal and the output terminal in a parallel manner in the embodiment of Fig. 16. Alternatively, according to the present invention, a plurality of transducers having a portion arranged at one major surface of the ferrimagnetic base and a portion arranged at the other major surface of this ferrimagnetic base may be parallel-connected between the input terminal and the output terminal.

It should be noted that the DC magnetic field is applied to the YIG thin film along such a direction parallel to the major surface of the YIG thin film and also parallel to the transducer in the above-described embodiments. As a result, the magnetostatic surface wave is excited in the thin film. Alternatively, the DC magnetic field may be applied to the YIG thin film along either a direction perpendicular to the major surface of this YIG thin film, or another direction parallel to the major surface of the YIG thin film and also perpendicular to the transducer. When the DC magnetic field is applied along the direction perpendicular to the major surface of the YIG thin film, a magnetostatic forward volume wave (MSFVW), which is another one of the three modes of magnetostatic waves, is excited in the YIG thin film. When the DC magnetic field is applied along the direction parallel to the major surface of the YIG thin film and also perpendicular to the transducer, a magnetostatic backward volume wave (MSBVW), which is still another one of the three modes of magnetostatic waves, is excited in the YIG thin film.

Since the respective embodiments of the present invention own not only the function to increase the S/N ratio of the RF signal, but also the function of the band-stop filter, these embodiments may be used as a band-stop filter.

## Claims

1. A magnetostatic wave device (10) comprising:
a ferrimagnetic base (12);
a transducer (16; 16a, 16b) having a portion arranged on one surface side of said ferrimagnetic base (12) and another portion arranged on the other surface side of said ferrimagnetic base (12);
an input terminal (18) whose one end is connected to one end of said transducer and whose the other end is grounded; and
an output terminal (20) whose one end is connected to the other end of said transducer and whose the other end is grounded.

2. The magnetostatic wave device (10) as claimed in claim 1 wherein said ferrimagnetic base (12) is disk-shaped.

3. The magnetostatic wave device (10) as claimed in claim 1, or claim 2, further comprising: another transducer having a portion (16b) arranged on one surface of said ferrimagnetic base (12) and another portion (16b) arranged on the other surface of said ferrimagnetic base (12), and connected in parallel to said transducer (16a).

4. A magnetostatic wave device (10) comprising:
a ferrimagnetic base (12);
one transducer (16a) having a portion arranged on one surface side of said ferrimagnetic base (12) and another portion arranged on the other surface side of said ferrimagnetic base (12);
another transducer (16b) having a portion arranged on the other surface side of said ferrimagnetic base (12) and another portion arranged on one surface side of said ferrimagnetic base (12);
an input terminal (18) whose one end is connected to one end of said one transducer (16a) and whose the other end is connected to one end of said another transducer (16b); and
an output terminal (20) whose one end is connected to the other end of said one transducer (16a) and whose the other end is connected to the other end of said another transducer (16b).

5. The magnetostatic wave device (10) as claimed in claim 4 wherein said ferrimagnetic base (12) is disk-shaped.

## Patentansprüche

1. Magnetostatisch-Welle-Bauelemente (10), mit folgenden Merkmalen:
einer ferrimagnetischen Basis (12);
einem Wandler (16; 16a, 16b), der einen an einer Oberflächenseite der ferrimagnetischen Basis (12) angeordneten Abschnitt und einen weiteren an der anderen Oberflächenseite der ferrimagnetischen Basis (12) angeordneten Abschnitt aufweist;
einem Eingangsanschluß (18) dessen eines Ende mit einem Ende des Wandlers verbunden ist, und dessen anderes Ende geerdet ist; und
einem Ausgangsanschluß (20) dessen eines Ende mit dem anderen Ende des Wandlers verbunden ist, und dessen anderes Ende geerdet ist.

2. Magnetostatisch-Welle-Bauelement (10) gemäß Anspruch 1, bei dem die ferrimagnetische Basis (12) scheibenförmig ist.

3. Magnetostatisch-Welle-Bauelement (10) gemäß Anspruch 1 oder Anspruch 2, das ferner folgendes Merkmal aufweist:
einen weiteren Wandler, der einen an einer Oberfläche der ferrimagnetischen Basis (12) angeordneten Abschnitt (16b) und einen weiteren an der anderen Oberfläche der ferrimagnetischen Basis (12) angeordneten und zu dem Wandler (16a) parallel geschalteten Abschnitt (16b) aufweist.

4. Magnetostatisch-Welle-Bauelement (10) mit folgenden Merkmalen:
einer ferrimagnetischen Basis (12);
einem Wandler (16a), der einen an einer Oberflächenseite der ferrimagnetischen Basis (12) angeordneten Abschnitt und einen weiteren an der anderen Oberflächenseite der ferrimagnetischen Basis (12) angeordneten Abschnitt aufweist;
einem weiteren Wandler (16b), der einen an der weiteren Oberflächenseite der ferrimagnetischen Basis (12) angeordneten Abschnitt und einen weiteren an einer Oberflächenseite der ferrimagnetischen Basis (12) angeordneten Abschnitt aufweist;
einem Eingangsanschluß (18) dessen eines Ende mit einem Ende des einen Wandlers (16a) verbunden ist, und dessen anderes Ende mit einem Ende des weiteren Wandlers (16b) verbunden ist; und
einem Ausgangsanschluß (20) dessen eines Ende mit dem weiteren Ende des einen Wandlers (16a) verbunden ist, und dessen weiteres Ende mit dem weiteren Ende des weiteren Wandlers (16b) verbunden ist.

5. Magnetostatisch-Welle-Bauelement (10) gemäß Anspruch 4, bei dem die ferrimagnetische Basis (12) scheibenförmig ist.

## Revendications

1. Dispositif (10) à ondes magnétostatiques, comprenant :
une base ferrimagnétique (12);
un transducteur (16 ; 16a, 16b) qui présente une partie disposée sur un côté de surface de ladite base ferrimagnétique (12) et une autre partie disposée sur l'autre côté de surface de ladite base ferrimagnétique (12);
une borne d'entrée (18) dont une extrémité est connectée à une extrémité dudit transducteur et dont l'autre extrémité est connectée à la masse électrique ; et
une borne de sortie (20) dont une extrémité est connectée à l'autre extrémité dudit transducteur et dont l'autre extrémité est connectée à la masse électrique.

2. Dispositif (10) à ondes magnétostatiques selon 1a revendication 1, où ladite base ferrimagnétique (12) est en forme de disque.

3. Dispositif (10) à ondes magnétostatiques selon la revendication 1 ou 2, comprenant en outre :
un autre transducteur qui présente une partie (16b) disposée sur une surface de ladite base ferrimagnétique (12) et une autre partie (16b) disposée sur l'autre surface de ladite base ferrimagnétique (12), et qui est connecté en parallèle avec ledit transducteur (16a).

4. Dispositif (10) à ondes magnétostatiques, comprenant :
une base ferrimagnétique (12);
un transducteur (16a) qui présente une partie disposée sur un premier côté de surface de ladite base ferrimagnétique (12) et une autre partie disposée sur l'autre côté de surface de ladite base ferrimagnétique (12) ;
un autre transducteur (16b) qui présente une partie disposée sur l'autre côté de surface de ladite base ferrimagnétique (12) et une autre partie disposée sur le premier côté de surface de ladite base ferrimagnétique (12);
une borne d'entrée (18) dont une extrémité est connectée à une extrémité dudit transducteur (16a) et dont l'autre extrémité est connectée à une extrémité dudit autre transducteur (16b) ; et
une borne de sortie (20) dont une extrémité est connectée à l'autre extrémité dudit transducteur (16a) et dont l'autre extrémité est connectée à l'autre extrémité dudit autre transducteur (16b).

5. Dispositif (10) à ondes magnétostatiques selon la revendication 4, où ladite base ferrimagnétique (12) est en forme de disque.
